# EUROPEAN PATENT APPLICATION

(11) **EP 3 768 003 A1**
(43) Date of publication of application: **20.01.2021**
(21) Application number: 18914087.4
(22) Date of filing: 02.05.2018
(51) Int. Cl.: H04W 52/52, H04W 52/54, H04W 88/02

(54) **MOBILE TERMINAL PERFORMING POWER CONTROL**

(30) Priority: 09.04.2018 US 201862655173 P
(71) Applicant: LG Electronics Inc., Yeongdeungpo-gu Seoul 07336 (KR)
(72) Inventor: KANG, Younghee, Seoul 06772 (KR); JANG, Jaehyuk, Seoul 06772 (KR); KIM, Jungrak, Seoul 06772 (KR)
(74) Representative: Vossius & Partner Patentanwälte Rechtsanwälte mbB
(86) International application number: PCT/KR2018/005114
(87) International publication number: WO 2019/198864

(57) **Abstract**

A mobile terminal for performing power control in accordance with the present invention comprises: a power tracker configured to supply a supply voltage to a power amplifier; and a bypass booster disposed between the battery and the power tracker and configured to boost the voltage from the battery through a booster or bypass without boosting the voltage through the booster, and the mobile terminal can also increase communication coverage in a new communication system in a higher frequency band.

## Description

### TECHNICAL FIELD

This application claims the benefit of priority to the application of U.S. Provisional Application Serial No. 62/655,173 filed on April 09, 2018, which application is incorporated herein by reference in its entirety.

The present disclosure relates to a mobile terminal configured to control power. More specifically, the present disclosure relates to a power control method for high power transmission and a mobile terminal performing the same.

### BACKGROUND ART

Terminals may be divided into mobile/portable terminals and stationary terminals according to mobility. Mobile terminals may also be classified as handheld terminals or vehicle mounted terminals according to whether or not a user can directly carry the terminal.

Mobile terminals have become increasingly more functional. Examples of such functions include data and voice communications, capturing images and video via a camera, recording audio, playing music files via a speaker system, and displaying images and video on a display. Some mobile terminals additionally provide functions such as playing an electronic game, or executing a function of multimedia players. Especially, recent mobile terminals may receive multicast signal for providing visual content such as broadcasts, videos, or television programs.

As it becomes multifunctional, a mobile terminal can be allowed to capture still images or moving images, play music or video files, play games, receive broadcast and the like, so as to be implemented as an integrated multimedia player.

Efforts are ongoing to support and increase the functionality of mobile terminals. Such efforts include software and hardware improvements, as well as changes and improvements in the structural components.

In addition to those attempts, the mobile terminals provide various services in recent years by virtue of commercialization of wireless communication systems using an LTE communication technology. In the future, it is expected that a wireless communication system using a 5G communication technology will be commercialized to provide various services.

In this regard, in a communication system using a high frequency band such as a 5G communication system, a coverage of a base station is reduced. Accordingly, there is a problem in that the number of base stations to be deployed in such a communication system increases.

To solve this problem, a high power (HP) transmission is needed between a base station and a mobile terminal, i.e., a user equipment (UE). In particular, since a transmission power of the mobile terminal (UE) is lower than that of the base station, a high power transmission is needed in an up link (UL) transmission from the mobile terminal to the base station. Therefore, the mobile terminal needs to operate as a high power UE (HPUE) to support high power transmission.

In this regard, in order for the mobile terminal to transmit high power, a supply voltage to a power amplifier (PA) should be increased.

However, a supply voltage provided by the mobile terminal to its internal components is limited to a predetermined value or less. In particular, depending on a charged state of the mobile terminal, such a supply voltage cannot be maintained at that level, and accordingly, the supply voltage to the power amplifier decreases. Therefore, even if it's needed, the mobile terminal cannot perform high power transmission due to the limit of the supply voltage to the power amplifier.

### DETAILED DESCRIPTION OF THE DISCLOSURE

### TECHNICAL PROBLEM

The present disclosure is directed to solving the aforementioned problems and other drawbacks. Another aspect is to provide a mobile terminal that performs high power transmission to a base station in order to increase communication coverage.

Another aspect of the present disclosure is to provide a mobile terminal that controls a supply voltage to a power amplifier for high power transmission.

### TECHNICAL SOLUTION

To achieve these and other advantages and in accordance with the purpose of this specification, as embodied and broadly described herein, there is provided a mobile terminal performing power control, including a power tracker configured to supply a supply voltage to a power amplifier, and a bypass booster disposed between a battery and the power tracker and configured to boost voltage from the battery through a booster or bypass without boosting the voltage through the booster. The mobile terminal can also increase communication coverage in a new communication system in a higher frequency band.

In an embodiment, the mobile terminal may further include an application processor (AP) capable of checking the voltage of the battery, and a modem configured to receive a high power (HP) transmission request from a base station and transmit a boosting control message to the AP in response to the high power transmission request.

In an embodiment, the AP that has received the boosting control message may check whether the voltage is a first voltage for normal power transmission or a second voltage for high power transmission. In addition, the AP may control the bypass booster to boost the first voltage from the battery to the second voltage, when the voltage is the first voltage.

In an embodiment, the AP may check whether the voltage is the first voltage or the second voltage, and when the voltage is the second voltage, may control the bypass booster so that an input signal is bypassed through a path different from that of the booster and the second voltage is supplied to the power tracker.

In an embodiment, the power tracker may include a power track module configured to detect a state of power outputted from the bypass booster. Here, a modem may control the power tracker to allow the power track module to be an off state, so that a signal passed through the booster is transmitted by bypassing the power track module.

In an embodiment, the modem may control the power tracker to allow the power track module to be an on state, so that the signal bypassed through the booster is transmitted through the power track module.

In an embodiment, the AP may check whether the voltage is a first voltage for normal power transmission or a second voltage for high power transmission. When the voltage is the first voltage, the AP may control the bypass booster to boost the first voltage from the battery to the second voltage. Here, the modem may control the signal passed through the booster to be transmitted by bypassing the power track module.

In an embodiment, the AP may check whether the voltage is the first voltage or the second voltage. When the voltage is the second voltage, the AP may control such that an input signal of the bypass booster is bypassed through a path different from that of the booster. Here, the modem may control the signal bypassed through the booster to be transmitted by bypassing the power track module.

In an embodiment, when the modem has not received the high power transmission request, the AP may check whether the voltage is the first voltage or the second voltage. In addition, when the voltage is the first voltage, the AP may control such that an input signal of the bypass booster is bypassed through a path different from that of the booster. Here, the modem may control the power tracker to allow the power track module to be an on state, so that the signal bypassed through the booster is transmitted through the power track module.

In an embodiment, when the modem receives the high power transmission request, the AP may check whether the voltage is the first voltage or the second voltage. Here, when the voltage is the second voltage, the bypass booster may boost the second voltage to a third voltage. Here, the modem may control the power tracker to allow the power track module to be an on state, so that the signal passed through the booster is transmitted through the power track module.

In an embodiment, the AP that has received the boosting control message from the modem in respond to the high power transmission request from the base station may check whether the voltage is a first voltage or a second voltage for high power transmission and whether a capacity of the battery is at or above a threshold value. Here, when the voltage is the second voltage and the capacity of the battery is at or below the threshold value, the modem may transmit a normal power (NP) mode request to the base station and receive an NP transmission request from the base station. In addition, when an NP transmission request is received from the base station, the AP may control the bypass booster to be bypassed through a path different from that of the booster so that the first voltage is supplied to the power tracker.

In an embodiment, when the modem has transmitted the boosting control message to the AP according to the high power transmission request from the base station, the power amplifier may receive a second voltage for high power (HP) transmission from the power tracker to operate in a high power transmission mode. Here, when the AP determines that the capacity of the battery is at or below the threshold value and the modem receives a normal power (NP) mode request from the AP, the power amplifier may receive a first voltage for NP transmission from the power tracker to operate in an NP transmission mode. Meanwhile, the power amplifier may receive a first input power from a transceiver in the NP transmission mode, and may receive a second input power higher than the first input power from the transceiver in the high power transmission mode.

To achieve these and other advantages and in accordance with the purpose of this specification, as embodied and broadly described herein, there is provided a mobile terminal performing power control, including a power amplifier, and a power controller configured to variably supply a supply voltage in accordance with an output power of the power amplifier. Here, the power controller may include a first power controller configured to supply a supply voltage to the power amplifier, and a second power controller disposed between a battery and the first power controller and configured to boost voltage from the battery through a booster or bypass without boosting the voltage through the booster.

In an embodiment, the mobile terminal may further include a controller configured to check the voltage of the battery, and to control the power tracker and the bypass booster. Here, the controller may include a first controller capable of checking the voltage of the battery, and a second controller configured to receive a high power (HP) transmission request from a base station and transmit a boosting control message to the first controller in response to the high power transmission request.

In an embodiment, the first controller that has received the boosting control message may check whether the voltage is a first voltage for normal power transmission or a second voltage for high power transmission. Here, when the voltage is the first voltage, the first controller may control the first power controller to boost the first voltage from the battery to the second voltage. In addition, when the voltage is the second voltage, the first controller may control the first power controller so that an input signal is bypassed through a path different from that of the booster and the second voltage is supplied to the second power controller.

### ADVANTAGEOUS EFFECTS

The effect of the mobile terminal configured to control voltage and power for high power transmission according to the present disclosure will be described as follows.

According to at least one of the embodiments of the present disclosure, by providing a mobile terminal that performs high power transmission to a base station, a communication coverage can be increased even in a new communication system of a high frequency band.

In addition, according to at least one of the embodiments of the present disclosure, there is provided a mobile terminal capable of performing a high power transmission regardless of a battery state by controlling a supply voltage to a power amplifier for high power transmission.

In addition, according to at least one of the embodiments of the present disclosure, there is an advantage in that by selectively detecting the power supplied to the power amplifier, high power transmission can be performed simultaneously with checking the state of the power amplifier.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

### BRIEF DESCRIPTION OF THE DRAWINGS

FIG. 1A is a block diagram of a mobile terminal according to the present disclosure.
FIGS. 1B and 1C are conceptual views illustrating one example of a mobile terminal according to the present disclosure, viewed from different directions.
FIG. 2 is a view of a mobile terminal configured to control voltage and power for high power transmission according to the present disclosure.
FIG. 3 illustrates a mobile terminal performing a boosting operation according to an embodiment of the present disclosure.
FIG. 4 illustrates a mobile terminal performing a bypass operation according to another embodiment of the present disclosure.
FIG. 5 illustrates an operation of bypassing a power track module as well when bypassing a booster according to still another embodiment of the present disclosure.
FIG. 6 illustrates an example in which a bypass booster and a power tracker are implemented in a single configuration according to an embodiment of the present disclosure.

### MODES FOR CARRYING OUT PREFERRED EMBODIMENTS

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the gist of the present disclosure, such explanation has been omitted but would be understood by those skilled in the art. The accompanying drawings are used to help easily understand the technical idea of the present disclosure and it should be understood that the idea of the present disclosure is not limited by the accompanying drawings. The idea of the present disclosure should be construed to extend to any alterations, equivalents and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be connected with the another element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

Mobile terminals presented herein may be implemented using a variety of different types of terminals. Examples of such terminals include cellular phones, smart phones, user equipment, laptop computers, digital broadcast terminals, personal digital assistants (PDAs), portable multimedia players (PMPs), navigators, portable computers (PCs), slate PCs, tablet PCs, ultra books, wearable devices (for example, smart watches, smart glasses, head mounted displays (HMDs)), and the like.

By way of non-limiting example only, further description will be made with reference to particular types of mobile terminals. However, such teachings apply equally to other types of terminals, such as those types noted above. In addition, these teachings may also be applied to stationary terminals such as digital TV, desktop computers, and the like.

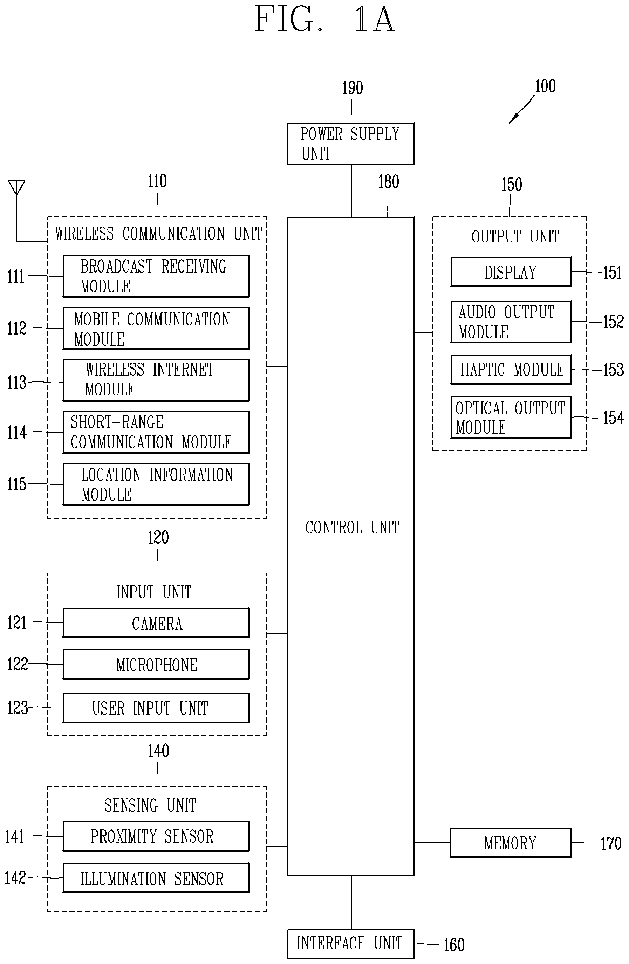

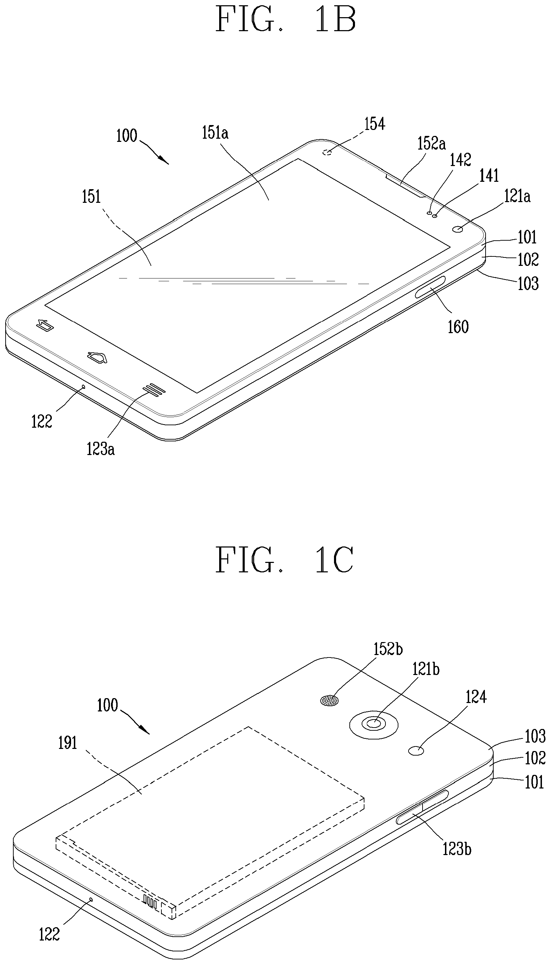

Referring to FIGS.1A to 1C, FIG. 1A is a block diagram of a mobile terminal in accordance with the present disclosure, and FIGS. 1B and 1C are conceptual views illustrating one example of a mobile terminal, viewed from different directions.

A mobile terminal 100 may be shown having components such as a wireless communication unit 110, an input unit 120, a sensing unit 140, an output unit 150, an interface unit 160, a memory 170, a controller 180, and a power supply 190. It is understood that implementing all of the components illustrated in FIG. 1A is not a requirement, and that greater or fewer components may alternatively be implemented.

In more detail, the wireless communication unit 110 may typically include one or more modules which permit communications such as wireless communications between the mobile terminal 100 and a wireless communication system, communications between the mobile terminal 100 and another mobile terminal, or communications between the mobile terminal 100 and an external server. Further, the wireless communication unit 110 may typically include one or more modules which connect the mobile terminal 100 to one or more networks.

The wireless communication unit 110 may include one or more of a broadcast receiving unit 111, a mobile communication module 112, a wireless Internet module 113, a short-range communication module 114, and a location information module 115.

The input unit 120 may include a camera 121 or an image input unit for obtaining images or video, a microphone 122, which is one type of audio input device for inputting an audio signal, and a user input unit 123 (for example, a touch key, a mechanical key, and the like) for allowing a user to input information. Data (for example, audio, video, image, and the like) may be obtained by the input unit 120 and may be analyzed and processed according to user commands.

The sensing unit 140 may typically be implemented using one or more sensors configured to sense internal information of the mobile terminal, the surrounding environment of the mobile terminal, user information, and the like. For example, the sensing unit 140 may include at least one of a proximity sensor 141, an illumination sensor 142, a touch sensor, an acceleration sensor, a magnetic sensor, a G-sensor, a gyroscope sensor, a motion sensor, a red, green, and blue (RGB) sensor, an infrared (IR) sensor, a finger scan sensor, a ultrasonic sensor, an optical sensor (for example, camera 121), a microphone 122, a battery gauge, an environment sensor (for example, a barometer, a hygrometer, a thermometer, a radiation detection sensor, a thermal sensor, and a gas sensor, among others), and a chemical sensor (for example, an electronic nose, a health care sensor, a biometric sensor, and the like). The mobile terminal disclosed herein may be configured to utilize information obtained from two or more sensors, and combinations thereof.

The output unit 150 may typically be configured to output various types of information, such as audio, video, tactile output, and the like. The output unit 150 may include at least one of a display 151, an audio output module 152, a haptic module 153, and an optical output module 154. The display 151 may have an inter-layered structure or an integrated structure with a touch sensor in order to implement a touch screen. The touch screen may function as the user input unit 123 which provides an input interface between the mobile terminal 100 and the user and simultaneously provide an output interface between the mobile terminal 100 and a user.

The interface unit 160 serves as an interface with various types of external devices that are coupled to the mobile terminal 100. The interface unit 160, for example, may include any of wired or wireless headset ports, external power supply ports, wired or wireless data ports, memory card ports, ports for connecting a device having an identification module, audio input/output (I/O) ports, video I/O ports, earphone ports, and the like. In some cases, the mobile terminal 100 may perform assorted control functions associated with a connected external device, in response to the external device being connected to the interface unit 160.

The memory 170 is implemented to store data to support various functions or features of the mobile terminal 100. For instance, the memory 170 may be configured to store application programs or applications executed in the mobile terminal 100, data or instructions for operations of the mobile terminal 100, and the like. At least one of these application programs may be downloaded from an external server via wireless communication. Other application programs may be installed within the mobile terminal 100 at time of manufacturing or shipping, which is the case for basic functions of the mobile terminal 100 (for example, receiving a call, placing a call, receiving a message, sending a message, and the like). Application programs may be stored in the memory 170, installed in the mobile terminal 100, and executed by the controller 180 to perform an operation (or function) for the mobile terminal 100.

A modem 180 typically functions to control an overall operation of the mobile terminal 100, in addition to the operations associated with the application programs. The modem 180 may provide or process information or functions appropriate for a user by processing signals, data, information and the like, which are input or output by the aforementioned various components, or activating application programs stored in the memory 170.

Also, the modem 180 may control at least some of the components illustrated in FIG. 1A, to execute an application program that has been stored in the memory 170. In addition, the modem 180 may control at least two of those components included in the mobile terminal 100 to activate the application program.

The power supply 190 may be configured to receive external power or provide internal power in order to supply appropriate power required for operating elements and components included in the mobile terminal 100. The power supply 190 may include a battery, and the battery may be configured to be embedded in the terminal body, or configured to be detachable from the terminal body.

At least part of the components may cooperatively operate to implement an operation, a control or a control method of a mobile terminal according to various embodiments disclosed herein. Also, the operation, the control or the control method of the mobile terminal may be implemented on the mobile terminal by an activation of at least one application program stored in the memory 170.

Referring to FIGS. 1B and 1C, the disclosed mobile terminal 100 includes a bar-like terminal body. However, the mobile terminal 100 may alternatively be implemented in any of a variety of different configurations. Examples of such configurations include watch type, clip-type, glasses-type, or a folder-type, flip-type, slide-type, swing-type, and swivel-type in which two and more bodies are combined with each other in a relatively movable manner, and combinations thereof. Discussion herein will often relate to a particular type of mobile terminal. However, such teachings with regard to a particular type of mobile terminal will generally apply to other types of mobile terminals as well.

Here, considering the mobile terminal 100 as at least one assembly, the terminal body may be understood as a conception referring to the assembly.

The mobile terminal 100 will generally include a case (for example, frame, housing, cover, and the like) forming an appearance of the terminal. In this embodiment, the case is formed using a front case 101 and a rear case 102. Various electronic components are interposed into a space formed between the front case 101 and the rear case 102. At least one middle case may be additionally positioned between the front case 101 and the rear case 102.

The display 151 is located on a front side of the terminal body to output information. As illustrated, a window 151a of the display 151 may be mounted in the front case 101 to form a front surface of the terminal body together with the front case 101.

The mobile terminal 100 may include the display 151, first and second audio output module 152a and 152b, the proximity sensor 141, the illumination sensor 142, the optical output module 154, first and second cameras 121a and 121b, first and second manipulation units 123a and 123b, the microphone 122, the interface unit 160, and the like.

Hereinafter, as illustrated in FIGS. 1B and 1C, description will be given of the exemplary mobile terminal 100 in which the front surface of the terminal body is shown having the display 151, the first audio output module 152a, the proximity sensor 141, the illumination sensor 142, the optical output module 154, the first camera 121a, and the first manipulation unit 123a, the side surface of the terminal body is shown having the second manipulation unit 123b, the microphone 122, and the interface unit 160, and the rear surface of the terminal body is shown having the second audio output module 152b and the second camera 121b.

However, those components may not be limited to the arrangement. Some components may be omitted or rearranged or located on different surfaces. For example, the first manipulation unit 123a may not be located on the front surface of the terminal body, and the second audio output module 152b may be located on the side surface of the terminal body other than the rear surface of the terminal body.

The display 151 is generally configured to output information processed in the mobile terminal 100. For example, the display 151 may display execution screen information of an application program executing at the mobile terminal 100 or user interface (Ul) and graphic user interface (GUI) information in response to the execution screen information.

The display 151 may include at least one of a liquid crystal display (LCD), a thin film transistor-LCD (TFT LCD), an organic light-emitting diode (OLED), a flexible display, a three-dimensional (3D) display and an e-ink display.

The display 151 may be implemented using two display devices, according to the configuration type thereof. For instance, a plurality of the displays 151 may be arranged on one side, either spaced apart from each other, or these devices may be integrated, or these devices may be arranged on different surfaces.

The display 151 may include a touch sensor that senses a touch with respect to the display 151 so as to receive a control command in a touch manner. Accordingly, when a touch is applied to the display 151, the touch sensor may sense the touch, and the modem 180 may generate a control command corresponding to the touch. Contents input in the touch manner may be characters, numbers, instructions in various modes, or a menu item that can be specified.

The first audio output module 152a may be implemented as a receiver for transmitting a call sound to a user's ear and the second audio output module 152b may be implemented as a loud speaker for outputting various alarm sounds or multimedia playback sounds.

The window 151a of the display 151 may include sound holes for emitting sounds generated from the first audio output module 152a. However, the present disclosure is not limited thereto, and the sounds may be released along an assembly gap between the structural bodies (for example, a gap between the window 151a and the front case 101). In this case, a hole independently formed to output audio sounds may not be seen or may otherwise be hidden in terms of appearance, thereby further simplifying the appearance of the mobile terminal 100.

The optical output module 154 may be configured to output light for indicating an event generation. Examples of such events may include a message reception, a call signal reception, a missed call, an alarm, a schedule alarm, an email reception, information reception through an application, and the like. When a user has checked a generated event, the modem 180 may control the optical output module 154 to stop the light output.

The first camera 121a may process image frames such as still or moving images obtained by the image sensor in a capture mode or a video call mode. The processed image frames can then be displayed on the display 151 or stored in the memory 170.

The first and second manipulation units 123a and 123b are examples of the user input unit 123, which may be manipulated by a user to provide input to the mobile terminal 100. The first and second manipulation units 123a and 123b may also be commonly referred to as a manipulating portion. The first and second manipulation units 123a and 123b may employ any method when it is a tactile manner allowing the user to perform manipulation with a tactile feeling such as touch, push, scroll or the like. The first and second manipulation units 123a and 123b may also be manipulated through a proximity touch, a hovering touch, and the like, without a user's tactile feeling.

The drawings are illustrated on the basis that the first manipulation unit 123a is a touch key, but the present disclosure may not be necessarily limited to this. For example, the first manipulation unit 123a may be configured as a mechanical key, or a combination of a touch key and a push key.

The content received by the first and second manipulation units 123a and 123b may be set in various ways. For example, the first manipulation unit 123a may be used by the user to input a command such as menu, home key, cancel, search, or the like, and the second manipulation unit 123b may be used by the user to input a command, such as controlling a volume level being output from the first or second audio output module 152a or 152b, switching into a touch recognition mode of the display 151, or the like.

As described above, with respect to the wireless communication unit 110, that is, the mobile communication module 111 and the wireless Internet module 112, a mobile terminal 100 configured to control voltage and power for high power transmission will be described below. Here, in a multiple communication system structure, a power control system in the wireless communication unit 110 interacts with the controller 180 that manages itself and the power supply 190.

Hereinafter, description will be given of embodiments of a mobile terminal configured to control voltage and power for high power transmission with reference to the accompanying drawings. It will be apparent to those skilled in the art that the present disclosure may be embodied in other specific forms without departing from the spirit or essential characteristics thereof.

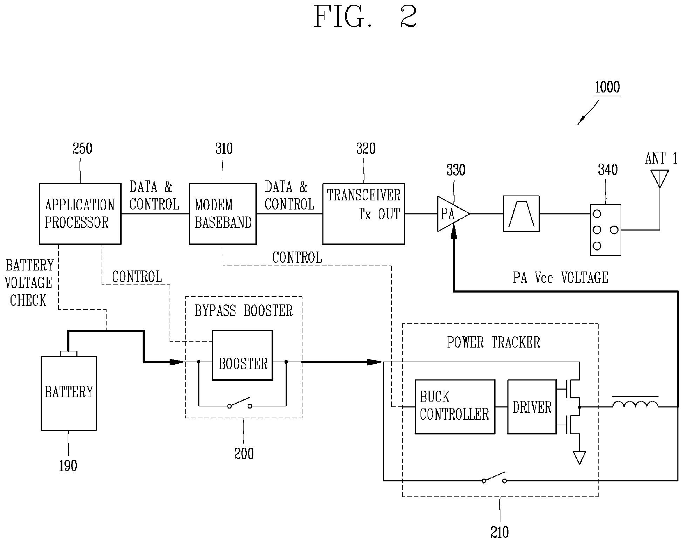

FIG. 2 is a view of a mobile terminal configured to control voltage and power for high power transmission according to the present disclosure. Referring to FIG. 2, a mobile terminal 1000 includes a power supply (or battery) 190, a bypass booster 200, and a power tracker 210. In addition, the mobile terminal 1000 includes an application processor (AP) 250, a modem 310, a transceiver 320, a power amplifier 330, and a switch 340. Meanwhile, a duplexer (or filter) configured to perform a frequency division duplex (FDD) may be disposed between the power amplifier 330 and the switch 340. Meanwhile, the switch 340 performs switching between a transmitter and a receiver in a time division duplex (TDD) method.

Here, the modem 310, the transceiver 320, the power amplifier 330, and the switch 340 constitute a first communication system. Meanwhile, apart from the modem 310, the transceiver 320, the power amplifier 330, and the switch 340, a second modem, a second power amplifier, and a second switch configured to operate in a second communication system may be provided. Here, the first communication system and the second communication system may be a 5G communication system and an LTE communication system, or vice versa. In the present disclosure, for convenience, a HPUE in the 5G communication system is described, but it is also applicable to a HPUE in the LTE communication system.

Meanwhile, for a power amplifier for high power transmission, the power tracker 210 is capable of detecting a status of the power amplifier and enhancing a capability of maximum transmission power through an envelope tracking (ET) method. However, in the ET method, an ET digital analog converter (DAC) should be supported, and an expensive component should be provided for high-performance ET detection. In addition, in a communication system with a wide bandwidth (BW), such as a 5G communication system, there is a problem in that performing wideband operation is difficult due to a limitation in bandwidth of a hardware for tracking an envelope. For example, even in 5G Sub 6 below 6 GHz band, it is difficult to implement the Tx band of 100 MHz band by the ET method.

The present disclosure proposes a method for boosting (or increasing) a supply voltage of the power amplifier 330 to satisfy the HPUE requirement. Specifically, a booster that boosts the supply voltage of the power amplifier 330 is controlled by an average power tracking (APT) method. To this end, the bypass booster 200 is connected to the power tracker 210 in a cascade manner.

The power tracker 210 is configured to supply a supply voltage to the power amplifier 330. Here, the supply voltage of the power amplifier 330 is typically about 3.5 V in a normal mode other than a high power mode. However, for the HPUE operation corresponding to a power class 2, the supply voltage of the power amplifier 330 is required to be at least 0.1 V to 1.5 V higher than 3.5 V. Therefore, for the HPUE operation, it is necessary to stably provide the supply voltage by increasing the supply voltage of the power amplifier 330. For example, a power transmitted to the base station through the power amplifier 330 in such a high power mode may be 26 dBm, but is not limited thereto.

Meanwhile, a cascade-type booster is not required in a general transmission section other than a high power transmission section, and when a cascade configuration is always used, the overall efficiency may be decreased.

In this regard, the bypass booster 200 is disposed between the battery 190 and the power tracker 210, and includes a booster and a switch. Here, the bypass booster 200 is configured to boost the voltage from the battery 190 through a booster or bypass the voltage without boosting through the booster. When the voltage of the battery 190 is boosted through the booster, the switch maintains an off state. On the other hand, when the battery 190 is not boosted through the booster, the switch maintains an on state.

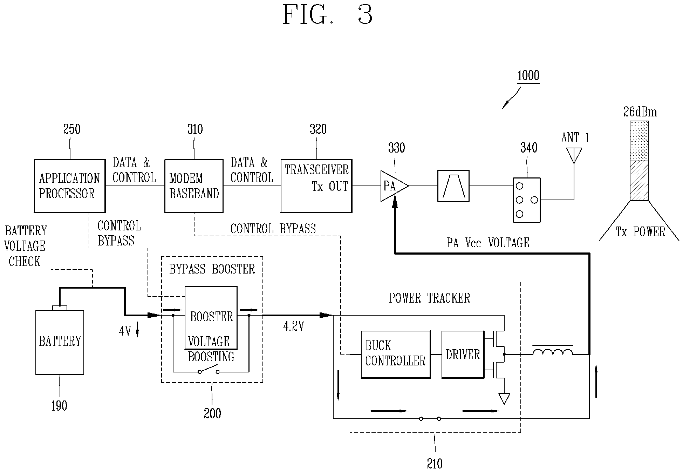

Hereinafter, a process of performing the boosting operation according to an embodiment of the present disclosure will be described in detail. In this regard, FIG. 3 illustrates a mobile terminal performing a boosting operation according to an embodiment of the present disclosure. Referring to FIG. 3, the AP 250 may check the voltage of the battery 190 and may perform a boosting operation through the bypass booster 200.

In this regard, the modem 310 that has received a high power transmission request from the base station requests the AP 250 for boosting. That is, the AP 250 may exchange data and control messages with the modem 310. In this case, the AP 250 may check the voltage of the battery 190 as described above. At this time, the modem 310 receives high power (HP) transmission request from the base station. Further, the modem 310 is configured to transmit a boosting control message to the AP 250 in response to the high power transmission request.

Accordingly, the AP 250 may control the bypass booster 200. Specifically, the AP 250 may control the bypass booster 200 to boost the booster. In this regard, the AP that has received the boosting control message may check whether the voltage is a first voltage for normal power transmission or a second voltage for high power transmission.

When the voltage is the first voltage, the AP controls the bypass booster 200 to boost the first voltage from the battery 190 to the second voltage through the booster. For example, the first voltage may be 4 V, and the second voltage boosted (intensified) through the bypass booster 200 may be 4.2 V, 4.3 V, or 4.5 V. The AP 250, having recognized the voltage intensified by the second voltage, may perform a bypass operation in the power tracker 210 to maintain the voltage. However, it is not limited thereto and may be variously changed according to the application.

Meanwhile, the power tracker 210 includes a power track module that detects a power state output from the bypass booster 200. Here, the power track module includes a buck controller that performs DC-DC control. In addition, the power track module further includes a driver connected to the buck controller to drive a supply voltage supplied to the power amplifier 330.

As described above, during the boosting operation through the booster, the modem 310 may allow the power tracker to be an off state, that is, may bypass the power tracker. In this regard, when the modem 310 receives the high power transmission request, the following operation may be performed. Here, the modem 310 may control the power tracker 210 such that the power track module is in an off state to allow the signal passed through the booster to be transmitted by bypassing the power track module, as illustrated in FIG. 3. In this case, the signal passed through the booster bypasses the power track module and is provided to the power amplifier 330 through a switch path corresponding to a separate path. Here, the switch provided in the switch path maintains an on state.

Meanwhile, during the boosting operation through the booster, the modem 310 may allow the power tracker to be an on state, that is, may drive the power tracker. In this regard, when the modem 310 receives a high power (HP) transmission request, the AP 250 checks whether the battery voltage is the first voltage for normal power transmission or the second voltage for high power transmission. When the voltage is the first voltage, the bypass booster 200 may boost the first voltage to the second voltage through a booster for high power (HP) transmission. On the other hand, when the voltage is the second voltage, the booster may be bypassed to provide the second voltage to the power tracker 210.

Meanwhile, when the voltage is the second voltage, the bypass booster 200 may boost the second voltage to a third voltage through the booster. Although the battery voltage is the second voltage for high power (HP) transmission, the voltage may be boosted to the third voltage to perform a power track operation.

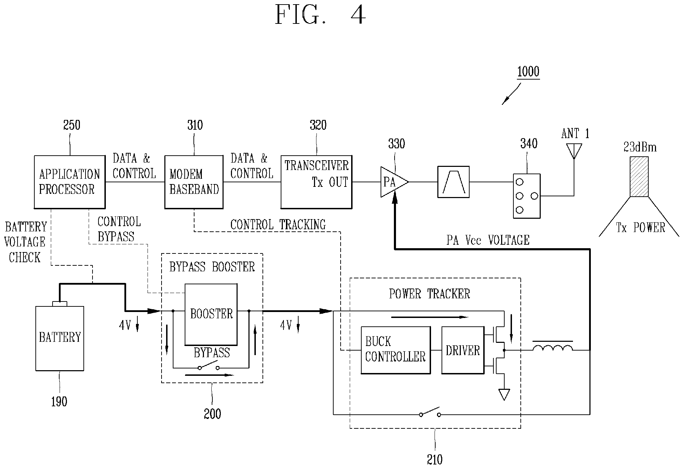

Meanwhile, when performing the bypass operation according to another embodiment of the present disclosure, the power track module may be operated or bypassed. In this regard, FIG. 4 illustrates a mobile terminal performing a bypass operation according to another embodiment of the present disclosure. Referring to FIG. 4, when the battery voltage signal bypasses the booster, the power track module in the power tracker 210 may be operated.

In this regard, when the modem 310 has not received the high power transmission request, the following operation may be performed. The modem 310 may control the power tracker 210 to allow the power track module to be an on state so that a signal bypassed the booster is transmitted through the power track module. That is, when a maximum transmission power, that is, high power transmission is not implemented regardless of the voltage of the battery 190, the power tracker 210 may be operated.

Specifically, when the modem 310 has not received the high power transmission request, the AP 250 checks whether the battery voltage is the first voltage for normal power transmission or the second voltage for high power transmission. Here, when the voltage is the first voltage, the AP 250 controls the input signal of the bypass booster 200 to be bypassed through a path different from that of the booster. At this time, the modem 310 may control the power tracker 210 to allow the power track module to be an on state so that a signal bypassed the booster is transmitted through the power track module.

In this case, the modem 310 notifies the AP 250 that it is not the maximum transmission power, and the AP 250 may be operated with its own efficiency according to the battery voltage without boosting.

Accordingly, a supply power suitable for the power supply of the power amplifier 330 is supplied to the power amplifier 330 through the power track module of the power tracker 210, and the power amplifier 330 operates in a normal mode. For example, a power transmitted to the base station through the power amplifier 330 in a normal mode may be 23 dBm, but is not limited thereto.

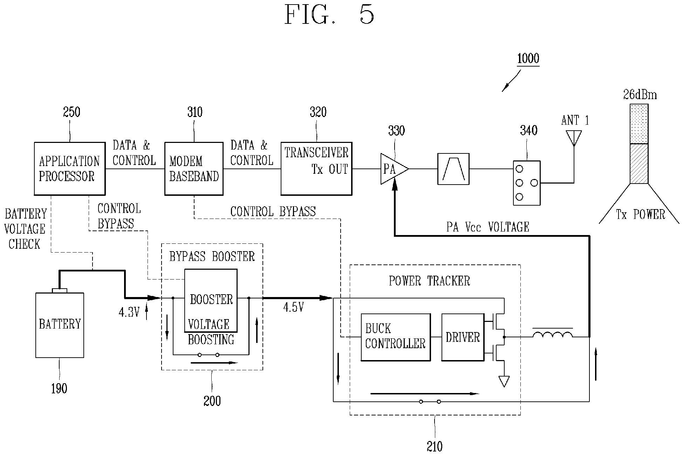

Meanwhile, when performing the bypass operation according to still another embodiment of the present disclosure, the power track module may be bypassed. In this regard, FIG. 5 illustrates an operation of bypassing a power track module as well when bypassing a booster according to still another embodiment of the present disclosure.

In this regard, the AP 250 may control the bypass booster 200 to be bypassed. In this regard, the AP 250 determines whether the voltage is the first voltage for normal power transmission or the second voltage for high power transmission. Accordingly, when the voltage is the second voltage, the AP 250 controls the bypass booster 200 so that an input signal is bypassed through a path different from that of the booster and the second voltage is supplied to the power tracker 210.

Here, the power tracker 210 may bypass the power track module to maintain the second voltage for high power transmission. That is, the modem 310 may control the signal bypassed through the booster to be transmitted by bypassing the power track module.

Accordingly, the signal provided from the bypass booster 200 is provided to the power amplifier 330 through a switch path that is a separate path from the power track module. Here, the second voltage is a voltage value higher than the first voltage. For example, the first voltage may be 4 V, and the second voltage may be 4.2 V, 4.3 V, or 4.5 V, but is not limited thereto and may be variously changed.

Meanwhile, as described above, the AP 250 checks whether the voltage is the first voltage for normal power transmission or the second voltage for high power transmission. Accordingly, when the voltage is the first voltage, the bypass booster 200 boosts the first voltage from the battery 190 to the second voltage through a booster. At this time, so that the second voltage for high power transmission is maintained, the modem 310 may control the signal passed through the booster to be transmitted by bypassing the power track module.

### (Additional Embodiment)

The foregoing description has been given of the on/off of the bypass booster 200 and the power tracker 210, that is, a pass/bypass control operation of the bypass booster 200 and the power tracker 210, to provide an HPUE that performs a high power (HP) transmission operation. Meanwhile, such a control operation may be performed further based on a remaining battery capacity in addition to a battery voltage level.

In this regard, the AP 250 that has received the boosting control message from the modem 310 according to the high power transmission request from the base station may perform the following operation. The AP 250 may check whether the battery voltage is the first voltage for normal power transmission or the second voltage for high power transmission, and whether the capacity of the battery is greater than or equal to a threshold value. In this case, when the voltage is the second voltage and the capacity of the battery is less than or equal to the threshold value, the following operation may be performed despite the high power transmission request. At this time, the modem 310 may send a normal power (NP) mode request to the base station. Here, the modem 310 may simultaneously transmit the request to an adjacent base station of the first communication system or a second base station of the second communication system in addition to a first base station of the first communication system. Accordingly, even if the corresponding base station does not receive the NP mode request, the NP mode request can be received by another base station, and thus, the corresponding base station has an advantage of being able to quickly perform the NP mode.

On the other hand, when the AP 250 receives the NP transmission request from the base station in response to the NP mode request, the bypass booster 200 is bypassed through a path different from that of the booster, and the bypass booster 200 may be controlled such that the first voltage is provided to the power tracker 210.

Meanwhile, a switching of high power (HP) transmission mode or normal power (NP) transmission mode of the power amplifier 330 and an operation of the transceiver 320 according to the switching will be described as follows. When the modem 310 transmits the boosting control message to the AP 250 according to the high power transmission request from the base station, the power amplifier 330 performs the following operation. The power amplifier 330 may operate in the high power transmission mode by receiving the second voltage for high power (HP) transmission from the power tracker 210.

Here, when the AP 250 determines that the capacity of the battery is less than the threshold value, and the modem 310 receives a normal power (NP) mode request from the AP 250, the power amplifier 330 operates as follows. The power amplifier 330 may receive the first voltage for normal power transmission from the power tracker 210 to operate in a normal power transmission mode.

Here, in the NP transmission mode, the power amplifier 330 receives the first input power from the transceiver 320. Meanwhile, in the high power transmission mode, the power amplifier 330 may receive the second input power higher than the first input power from the transceiver 320. Accordingly, the power amplifier 330 having received the second input power that is higher than the first input power has an advantage that it does not need to increase a gain value even in the high power transmission mode. For example, when the first input power of the power amplifier 330 that needs to transmit 23 dBm in the NP transmission mode is 3 dBm, a gain of the power amplifier 330 should be 20 dB.

On the other hand, when the same first input power is applied to the power amplifier 330 that needs to transmit 26 dBm in the high power transmission mode, the gain of the power amplifier 330 should be increased to 23 dB. However, in the high power transmission mode, the second input power, for example 6 dBm, may be applied to the power amplifier 330 that needs to transmit 26 dBm. In this case, when the second input power, for example 6 dBm, is applied to the power amplifier 330, the gain of the power amplifier 330 can be maintained at 20 dB even in the high power transmission mode, which is the same as in the NP transmission mode.

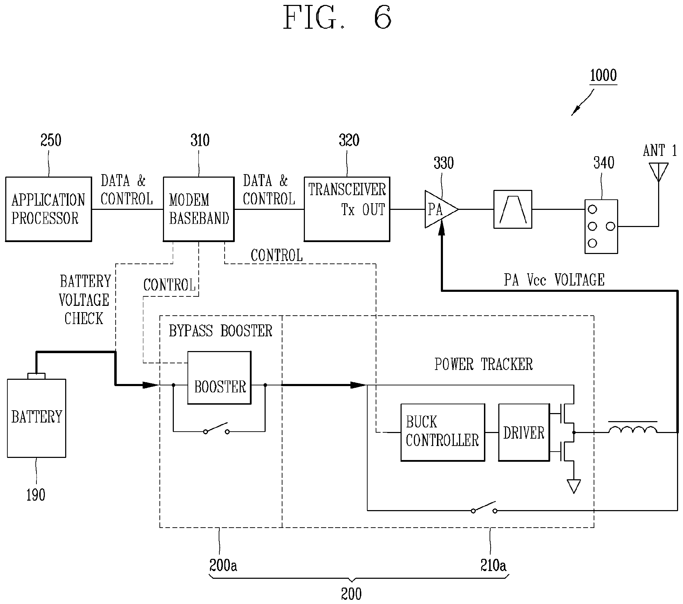

Meanwhile, the above described bypass booster 200 and power tracker 210 may be implemented as a single device. In this regard, FIG. 6 illustrates an example in which a bypass booster and a power tracker are implemented in a single configuration according to an embodiment of the present disclosure. In FIGS. 2 to 5, the bypass booster 200 and the power tracker 210 are arranged in a cascade formation to perform high power (HP) transmission and/or normal power (NP) transmission. On the other hand, in FIG. 6, the bypass booster 200 and the power tracker 210 of FIGS. 2 to 5 are implemented as a single power controller 200.

As described above, the power tracker 210 and the bypass booster 200 performing power control of the mobile terminal 1000, that is, transmitting normal power (NP) or transmitting high power (HP), may be referred to as a power controller. Meanwhile, referring to FIGS. 2 to 6, the operation of the HPUE described above from a viewpoint of the power controller and the controller described below is as follows. Here, the power tracker 210 and the bypass booster 200 may be referred to as a first power controller 210a and a second power controller 200a, respectively. Here, the first power controller 210a and the second power controller 200a are physically disposed in one piece of hardware, but are considered to be functionally separable.

In this regard, the power controller variably supplies a supply voltage according to an output power of the power amplifier 330. Specifically, the first power controller 210a is configured to supply a supply voltage to the power amplifier 330 and detect a power state of the power amplifier 330. Meanwhile, the second power controller 200a is disposed between the battery 190 and the first power controller 210a, and performs a battery voltage boosting operation. Specifically, the second power controller 200a is configured to boost the voltage from the battery 190 through a booster or bypass the voltage without boosting through the booster.

Meanwhile, the AP 250 and the modem 310 that exchange data with a control message of the mobile terminal 1000 and control the power controllers 200 and 210 described above may be referred to as a controller. Here, the AP 250 and the modem 310 may be referred to as a first controller 250 and a second controller 310, respectively.

Meanwhile, referring to FIG. 6, a checking of the battery voltage and the control operation of the power controller 200 can be performed only by the second controller 310 corresponding to the modem 310. As such, when voltage and power is controlled by the second controller 310, there are following advantages. That is, a control complexity is reduced compared to a case where both the first controller 250 and the second controller 310 control voltage and power. However, even in this case, the first controller 250 should transmit a control message for normal power (NP) transmission or high power (HP) transmission from the base station to the second controller 310.

Meanwhile, as illustrated in FIGS. 2 to 5, check of the battery voltage and control of the second power controller 200 may be performed by the first controller 250.

Here, the first controller 250 may check the voltage of the battery 190. Meanwhile, the second controller 310 is configured to receive a high power (HP) transmission request to transmit a boosting control message to the first controller 310 in response to the high power transmission request.

Meanwhile, the first controller 310 that has received the boosting control message checks whether the battery voltage is the first voltage for normal power transmission or the second voltage for high power transmission. Here, when the voltage is the first voltage, the first controller 310 controls the first power controller 210a so that the first power controller 210a boosts the first voltage from the battery 190 to the second voltage.

On the other hand, when the voltage is the second voltage, the first controller 310 controls the first power controller 210a so that the input signal is bypassed through a path different from that of the booster and the second voltage is supplied to the second power controller 220.

Meanwhile, the contents described in FIGS. 2 to 5 can be applied from a perspective of the first power controller 210a, the second power controller 200a, the first controller 250, and the second controller 310.

In the foregoing, the mobile terminal configured to control voltage and power for high power transmission according to the present disclosure has been described. The mobile terminal performing such power control has the following characteristics.

According to at least one of the embodiments of the present disclosure, a communication coverage can be increased even in a new communication system of a high frequency band by providing a mobile terminal that performs high power transmission to a base station.

In addition, according to at least one of the embodiments of the present disclosure, there is provided a mobile terminal capable of performing a high power transmission regardless of a battery state by controlling a supply voltage to a power amplifier for high power transmission.

In addition, according to at least one of the embodiments of the present disclosure, there is an advantage in that by selectively detecting the power supplied to the power amplifier, high power transmission can be performed simultaneously with checking the state of the power amplifier.

Further scope of applicability of the present disclosure will become apparent from the following detailed description. It should be understood, however, that the detailed description and specific examples, such as the preferred embodiment of the disclosure, are given by way of illustration only, since various changes and modifications within the spirit and scope of the disclosure will be apparent to those skilled in the art.

In relation to the aforementioned present disclosure, a design of a mobile terminal configured to control voltage and power for high power transmission and an operation of the same can be implemented as computer-readable codes in a program-recorded medium. The computer-readable media may include all types of recording devices each storing data readable by a computer system. Examples of such computer-readable medium may include hard disk drive (HDD), solid state disk (SSD), silicon disk drive (SDD), ROM, RAM, CD-ROM, magnetic tape, floppy disk, optical data storage element and the like. Also, the computer-readable media may also be implemented as a format of carrier wave (e.g., transmission via an Internet). The computer may include the controller 180 of the terminal. Therefore, it should also be understood that the above-described embodiments are not limited by any of the details of the foregoing description, unless otherwise specified, but rather should be construed broadly within its scope as defined in the appended claims. Therefore, all changes and modifications that fall within the metes and bounds of the claims, or equivalents of such metes and bounds are therefore intended to be embraced by the appended claims.

## Claims

1. A mobile terminal, comprising:
a power tracker configured to supply a supply voltage to a power amplifier; and
a bypass booster disposed between a battery and the power tracker and configured to boost voltage from the battery through a booster or bypass without boosting the voltage through the booster.

2. The mobile terminal of claim 1, further comprising:
an application processor (AP) capable of checking the voltage of the battery; and
a modem configured to receive a high power (HP) transmission request from a base station and transmit a boosting control message to the application processor in response to the high power transmission request.

3. The mobile terminal of claim 2, wherein the application processor that has received the boosting control message is configured to:
check whether the voltage is a first voltage for normal power transmission or a second voltage for high power transmission, and
when the voltage is the first voltage, control the bypass booster to boost the first voltage from the battery to the second voltage.

4. The mobile terminal of claim 3, wherein the application processor is configured to check whether the voltage is the first voltage or the second voltage, and
when the voltage is the second voltage, control the bypass booster so that an input signal is bypassed through a path different from that of the booster and the second voltage is supplied to the power tracker.

5. The mobile terminal of claim 3, wherein the power tracker comprises:
a power track module configured to detect a state of power outputted from the bypass booster; and
a modem configured to control the power tracker to allow the power track module to be an off state, so that a signal passed through the booster is transmitted by bypassing the power track module.

6. The mobile terminal of claim 5, wherein the modem controls the power tracker to allow the power track module to be an on state, so that the signal bypassed through the booster is transmitted through the power track module.

7. The mobile terminal of claim 5, further comprising:
an application processor (AP) capable of checking the voltage of the battery,
wherein the application processor is configured to:
check whether the voltage is a first voltage for normal power transmission or a second voltage for high power transmission, and
when the voltage is the first voltage, allow the bypass booster to boost the first voltage from the battery to the second voltage through a booster, and
wherein the modem controls the signal passed through the booster to be transmitted by bypassing the power track module.

8. The mobile terminal of claim 7, wherein the application processor is configured to:
check whether the voltage is the first voltage or the second voltage, and
when the voltage is the second voltage, control such that an input signal of the bypass booster is bypassed through a path different from that of the booster, and
wherein the modem controls the signal bypassed through the booster to be transmitted by bypassing the power track module.

9. The mobile terminal of claim 7, when the modem has not received the high power transmission request,
wherein the application processor is configured to:
check whether the voltage is the first voltage or the second voltage, and
when the voltage is the first voltage, control such that an input signal of the bypass booster is bypassed through a path different from that of the booster, and
wherein the modem controls the power tracker to allow the power track module to be an on state, so that the signal bypassed through the booster is transmitted through the power track module.

10. The mobile terminal of claim 7, when the modem receives the high power transmission request,
wherein the application processor is configured to:
check whether the voltage is the first voltage or the second voltage, and
when the voltage is the second voltage, allow the bypass booster to boost the second voltage to a third voltage, and
wherein the modem controls the power tracker to allow the power track module to be an on state, so that the signal passed through the booster is transmitted through the power track module.

11. The mobile terminal of claim 2, wherein the application processor that has received the boosting control message from the modem in respond to the high power transmission request from the base station is configured to:
check whether the voltage is a first voltage or a second voltage for high power transmission and whether a capacity of the battery is at or above a threshold value,
allow a modem to transmit a normal power (NP) mode request to the base station, when the voltage is the second voltage and the capacity of the battery is at or below the threshold value, and
control the bypass booster to be bypassed through a path different from that of the booster so that the first voltage is supplied to the power tracker, when a normal power transmission request is received from the base station.

12. The mobile terminal of claim 2, wherein the power amplifier is configured to:
when the modem has transmitted the boosting control message to the application processor according to the high power transmission request from the base station, receive a second voltage for high power (HP) transmission from the power tracker to operate in a high power transmission mode, and
when the application processor determines that the capacity of the battery is at or below the threshold value and the modem receives a normal power (NP) mode request from the application processor, receive a first voltage for normal power transmission from the power tracker to operate in a normal power transmission mode,
wherein the power amplifier is further configured to:
receive a first input power from a transceiver in the normal power transmission mode, and
receive a second input power higher than the first input power from the transceiver in the high power transmission mode.

13. A mobile terminal, comprising:
a power amplifier; and
a power controller configured to variably supply a supply voltage in accordance with an output power of the power amplifier,
wherein the power controller comprises:
a first power controller configured to supply a supply voltage to the power amplifier; and
a second power controller disposed between a battery and the first power controller and configured to boost voltage from the battery through a booster or bypass without boosting the voltage through the booster.

14. The mobile terminal of claim 13, further comprising:
a controller configured to check the voltage of the battery, and to control the power tracker and the bypass booster,
wherein the controller comprises:
a first controller capable of checking the voltage of the battery; and
a second controller configured to receive a high power (HP) transmission request from a base station and transmit a boosting control message to the first controller in response to the high power transmission request.

15. The mobile terminal of claim 14, wherein the first controller that has received the boosting control message is configured to:
check whether the voltage is a first voltage for normal power transmission or a second voltage for high power transmission,
when the voltage is the first voltage, control the first power controller to boost the first voltage from the battery to the second voltage, and
when the voltage is the second voltage, control the first power controller so that an input signal is bypassed through a path different from that of the booster and the second voltage is supplied to the second power controller.
